# EUROPEAN PATENT APPLICATION

(11) **EP 1 065 737 A2**
(43) Date of publication of application: **03.01.2001**
(21) Application number: 00113461.8
(22) Date of filing: 26.06.2000
(51) Int. Cl.: H01L 51/20

(54) **Organic electroluminescent device**

(30) Priority: 28.06.1999 US 340785
(71) Applicant: MOTOROLA, INC., Schaumburg, IL 60196 (US)
(72) Inventor: Choong, Vi-en, Chandler, Arizona 85226 (US); So, Franky, Coral Springs, Florida 33071 (US)
(74) Representative: Treleven, Colin

(57) **Abstract**

An organic electroluminescent device (10) composed of a body of small molecule organic material(s) (16) sandwiched between a first (14) and a second (18) electrode, wherein the body of small molecule organic material (16) is in direct contact with the electrodes (14 and 18). The body of small molecule organic material (16) is comprised of bipolar materials defined as having the capability of transporting both electrons and holes, designated a bipolar transport emitting layer (BTEL). One of the preferred bipolar materials has a general formula of AₓB_{y}, where A is a component capable of transporting electrons, B is a component capable of transporting holes, x represents the content of the A component, and y represents the content of the B component.

## Description

### Field of the Invention

The present invention pertains to electroluminescent devices and more particularly to structures for improving the efficiency of electroluminescent devices.

### Background of the Invention

Organic electroluminescent (EL) devices are generally composed of three layers of organic materials sandwiched between transparent and metallic electrodes, the three layers include an electron transporting layer, an emissive layer and a hole transporting layer. Organic EL devices are attractive owing to the merits of low driving voltage and capability for full color flat emissive displays. Though significant lifetime has been achieved in the prior art (See U.S. Pat. No. 4,720,432), further improvement is needed for applications where high brightness is required. Among other things, device structure modification to enhance carrier injection efficiently and confine carriers in the layers of organic materials to increase the recombination probability is essential to improve the lifetime of organic electroluminescent devices.

In an article by Tang et al., entitled "Fabrication and Electroluminescence of Double-Layered Organic Light Emitting Diodes with the Al₂O₃/Al Cathode", *Appl.* *Phys. Lett.*, vol. 70, No. 10, pp. 1233-1235, 10 Mar. 1997, a buffer layer of Al₂O₃ is positioned between a layer of Alq₃ (electron transporting and emissive layer) and an aluminum electrode (cathode). The buffer layer provides enhanced tunneling and removes exciton-quenching gap states that are intrinsic to the Alq₃/Al interface.

An article by Parker et al., entitled "Fabrication of Polymer Light-Emitting Diodes Using Doped Silicon Electrodes", *Appl. Phys. Lett.*, Vol. 64, No. 14, pp. 1774-1776, 4 Apr. 1994, discloses the use of a doped silicon electrode and an SiO₂ layer on the polymer diode so as to enable the fabrication of polymer LEDs directly on a silicon substrate and the consequent integration of the polymer LEDs into silicon based integrated circuitry.

In U.S. Pat. No. 5,853,905 discloses the elimination of the heterojunction interface, with an electroluminescent device composed of a body of small molecule organic material(s) sandwiched between a first and a second electrode, wherein a layer of first insulative material is placed between the body of small molecule organic material(s) and the first electrode, and an optional layer of second insulative material is placed between the body of small molecule organic material(s) and the second electrode. It is believed that the first insulative material allows first carriers from the first electrode to tunnel therethrough and the second insulative material provides a barrier to the first carriers. Although this structure does improve both the efficiency and reliability of the device, it also adds additional process steps to the fabrication of the device.

Accordingly, there is a need to simplify the structure of an organic electroluminescent device so that it can be fabricated inexpensively. However, the simplification should not come at the expense of the lifetime and efficiency of the device. Also, the elimination of the interface between electron transporting and hole transporting layers will result in an electroluminescent device with improved reliability.

It is a purpose of the present invention to provide a new and simplified electroluminescent device.

It is another purpose of the present invention to provide a new and simplified electroluminescent device with high efficiency and reliability.

It is still another purpose of the present invention to provide a new and simplified electroluminescent device with a simplified structure thereby eliminating process steps from the fabrication procedure.

It is a further purpose of the present invention to provide a new and improved electroluminescent device which can be fabricated inexpensively.

### Summary of the Invention

The above purposes and others are realized in an electroluminescent device composed of a body of small molecule organic material(s) sandwiched between a first and a second electrode, wherein a body of small molecule organic material is in direct contact with the electrodes. The body of small molecule organic material is comprised of bipolar materials defined as having the capability of transporting both electrons and holes, designated a bipolar transport emitting layer (BTEL). One of the preferred bipolar materials has a general formula of AₓB_{y}, where A is a component capable of transporting electrons, B is a component capable of transporting holes, x represents the content of the A component, and y represents the content of the B component. By judicious choice of the electrode material, which includes metals, metal alloys, conducting polymers, metal compounds, etc., efficient injection of charges into the BTEL layer can be achieved, which are comparable or better than in the presence of an insulative layer between the electrode and the body of small molecules.

### Brief Description of the Drawings

The novel features believed characteristic of the invention are set forth in the claims. The invention itself, however, as well as other features and advantages thereof will be best understood by reference to detailed descriptions which follow, when read in conjunction with the accompanying drawings, wherein:
FIG. 1 is a simplified sectional view of an organic electroluminescent device in accordance with the present invention; and
FIG. 2 is a simplified sectional view of an alternative embodiment of an organic electroluminescent device in accordance with the present invention.

### Detailed Description of the Drawings

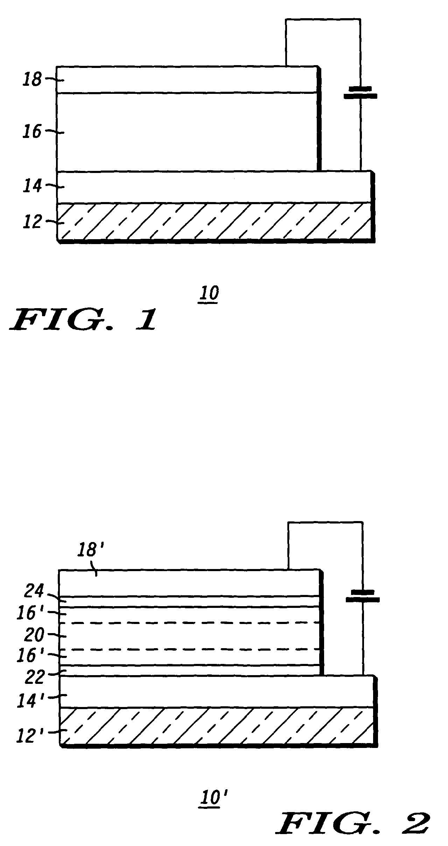

During the course of this description, like numbers are used to identify like elements according to the different figures that illustrate the embodiments of the invention. Turning now to FIG. 1, a simplified sectional view of an organic electroluminescent (EL) device 10 in accordance with the present invention is illustrated. Device 10 is fabricated upon a substrate 12 which, in this embodiment, is preferably transparent and may be fabricated of any of the number of known materials employed in the art. For example, substrate 12 may be fabricated of a glass, such as a Coming 7059 glass, transparent plastic substrates made of polyolefins, polyethersulfones, polyarylates, etc. In one preferred embodiment, substrate 12 is fabricated of glass of a quality good for flat panel display applications.

Deposited atop substrate 12 is a first electrode 14, which is electrically conductive and optically transparent or semi-transparent. Several materials may be advantageously employed as first electrode 14 for an organic EL device. Examples of materials include conductive metal oxides such as indium oxide, indium-tin oxide (ITO), zinc oxide, zinc-tin oxide, conductive transparent polymers such as polyaniline. Alternatively, electrode 14 may be fabricated of a semi-transparent metal, examples of which include a thin layer (<500 Å) of gold, copper, silver, and combinations thereof. In one preferred embodiment, electrode 14 is fabricated of ITO or zinc oxide.

Thereafter, deposited atop electrode 14 is a single body of organic electroluminescent medium 16 where light emission takes place. In this embodiment, organic electroluminescent medium 16 is composed of a continuous organic medium without heterojunctions and is in direct contact with electrode 14 and the top electrode (discussed presently). Generally, medium 16 has a bandgap in a range from 1.5 to 3.5 and preferably in a range from 1.8 to 3. It is preferred that medium 16 is made of small molecule organic material(s). Medium 16 is comprised of bipolar materials defined as having the capability of transporting both electrons and holes, also referred to as a bipolar transport emitting layer (BTEL). In a preferred embodiment, medium 16 has a general formula of AₓB_{y}, where A is a component capable of transporting electrons, B is a component capable of transporting holes, x represents the content of the A component in the AxBy, and y represents the content of the B component in the AxBy medium. While variations of X and Y across medium 16 will generally be substantially linear, it will be understood by those skilled in the art that variations other than linear may be incorporated in specific applications.

Electrode 14 is chosen specifically to include metals, metal alloys, conducting polymers metal compounds, etc., whereby efficient injection of charges into the BTEL layer, or medium, 16 can be achieved, which are comparable or more efficient than in the presence of an insulative layer between electrode 14 and the body of small molecules, or BTEL layer 16. The carrier transport properties can be changed by adjusting the composition of BTEL layer 16. For example, when y=1 or is at 100%, BTEL layer 16 consists purely of hole transport (HT) material, and the hole transport is strongly favored, and on the other hand, when y=0, BTEL layer 16 is the electron transport (ET) material and the electron transport is favored. In both of these cases, the EL efficiency is low because the carrier injection and transport is not balanced. Most carriers traverse BTEL layer 16 without recombining radiatively. The reliability also suffers in this case as the leakage current is high. When y is not equal to zero, both ET and HT molecules co-exist in the mixture. Due to the existence of weak van der Waals coupling between the molecules, the narrow bands of highest occupied molecular orbitals (HOMOs) and the lowest unoccupied molecular orbitals (LUMOs) of both HT and ET molecules still retain their original energies in the mixture. For example, electrons still hop through the ET LUMOs and holes through the HT HOMOs. By varying the composition of BTEL layer 16, the average hopping distance for the carriers can be controlled. For example, for small y (low NPB concentration), the average hopping distance for holes would be greater, resulting in lower hole mobility. Therefore, the location of the recombination zone can be controlled by adjusting the composition of BTEL layer 16. The composition of BTEL layer 16 need not be fixed for the entire layer. The composition of BTEL layer 16 can be continuously adjusted throughout BTE layer 16 as desired to optimize device performance. Thus, the need for a layer of insulative material positioned between BTEL layer 16 and electrode 14 and the top electrode (discussed presently) to provide a barrier against the carriers leaking into the electrodes is eliminated. This results in a much simpler structure without sacrificing efficiency or reliability.

Deposited atop BTEL layer 16 is a second electrode 18 (cathode) which is typically formed of a metal selected from a group of lithium, magnesium, calcium, or strontium, aluminum, indium, copper, gold, silver, or a combination of the above metals.

Referring now to FIG. 2, one important embodiment of the present invention is directed toward the improvement of the organic EL efficiency as well as control of emission color. Accordingly, illustrated in simplified sectional view is an alternative embodiment of the electroluminescent device of the present invention. It should be noted that all components similar to the components illustrated in FIG. 1 are designated with similar numbers, having a prime added to indicate the different embodiment. This purpose can be achieved by incorporation of a small fraction of a dye or pigment 20 of high fluorescent efficiency into BTEL 16. For efficient transfer, it is necessary that the fluorescent dye or pigment has a bandgap no greater than that of the host material making up BTEL 16. It is preferred that the fluorescent dye or pigment is present in a concentration of from 10⁻³ to 10 mole percent, based on the moles of the material forming BTEL 16. The selection of a fluorescent dye or pigment suitable for organic EL applications is well known to those skilled in the art. In addition, as illustrated in FIG. 2, optionally included is a hole injection layer 22 sandwiched between BTEL 16' and first electrode 14' and/or an electron injection layer 24 sandwiched between BTEL 16' and second electrode 18'. The inclusion of at least one of hole injection layer 22 and/or electron injection layer 24 provides for a more stable and efficient device by improving the thermal expansion coefficients between first or second electrodes 16' or 18' and BTEL 16'.

Therefore, a new efficient single layer electroluminescent device is disclosed. Further, the new efficient single layer electroluminescent device is relatively simple to manufacture and has substantially better stability than multi-layer devices. Also, the new efficient single layer electroluminescent device has better reliability than multilayer devices because it has fewer interface.

While we have shown and described specific embodiments of the present invention, further modifications and improvements will occur to those skilled in the art. We desire it to be understood, therefore, that this invention is not limited to the particular forms shown and we intend in the appended claims to cover all modifications that do not depart from the spirit and scope of this invention.

## Claims

1. An organic electroluminescent device (10) characterised by a body of small molecule organic material(s) (16) sandwiched between a first electrode (14) and a second electrode (18), the body of small molecule organic material(s) in direct contact with the first electrode and the second electrode and formed of a bipolar material having electron transporting and hole transporting properties.

2. An organic electroluminescent device as claimed in claim 1 wherein the body of small molecule organic material includes a continuous organic medium AₓB_{y}, where A is a component capable of transporting electrons, B is a component capable of transporting holes, x represents the content of the A component in the AₓB_{y} medium with value ranging from 0 to 100 %, y represents the content of the B component in the AₓB_{y} medium with value ranging from 0 to 100%.

3. An organic electroluminescent device as claimed in claim 1 wherein the body of small molecule organic material (16) includes a fluorescent dye or pigment in a concentration of from 10⁻³ to 10 mole percent, based on the moles of the small molecule organic material in the body.

4. An organic electroluminescent device as claimed in claim 1 wherein the first electrode (14) includes transparent conductive metal oxides such as indium oxide, indium-tin oxide (ITO), zinc oxide, zinc-tin oxide, transparent conductive polymers such as polyaniline, or semi-transparent thin film of metal selected from gold, copper, silver, and combinations thereof.

5. An organic electroluminescent device as claimed in claim 1 wherein at least one of a hole injection layer (22) is sandwiched between the body of small molecule organic material (16) and the first electrode (14) and an electron injection layer (24) is sandwiched between the body of small molecule organic material (16) and the second electrode (18).

6. An organic electroluminescent device (10) characterised by:
a body of small molecule organic material (16) sandwiched between a first electrode (14) and a second electrode (18);
the body or organic material in direct contact with a surface of the first electrode and a surface of the second electrode;
the body of organic material having a bandgap between 1.5 and 3.5 eV; and
the body of organic material formed of a bipolar material including hole transporting properties and electron transporting properties.

7. An organic electroluminescent device as claimed in claim 6 wherein the body of small molecule organic material (16) includes a continuous organic medium AₓB_{y}, where A is a component capable of transporting electrons, B is a component capable of transporting holes, x represents the content of the A component in the AₓB_{y} medium with value ranging from 0 to 100%, y represents the content of the B component in the AₓB_{y} medium with value ranging from 0 to 100%.

8. An organic electroluminescent device as claimed in claim 6 wherein the body of small molecule organic material (16) includes a fluorescent dye or pigment (20) in a concentration of from 10⁻³ to 10 mole percent, based on the moles of the small molecule organic material in the body.

9. An organic electroluminescent device as claimed in claim 6 wherein the first electrode (14) includes transparent conductive metal oxides such as indium oxide, indium-tin oxide (ITO), zinc oxide, zinc-tin oxide, transparent conductive polymers such as polyaniline, or semi-transparent thin film of metal selected from gold, copper, silver, and combinations thereof.

10. An organic electroluminescent device as claimed in claim 6 wherein at least one of a hole injection layer (22) is sandwiched between the body of small molecule organic material (16) and the first electrode (14) and an electron injection layer (24) is sandwiched between the body of small molecule organic material (16) and the second electrode (18).
